# EUROPEAN PATENT APPLICATION

(11) **EP 2 584 586 A1**
(43) Date of publication of application: **24.04.2013**
(21) Application number: 11795646.6
(22) Date of filing: 10.06.2011
(51) Int. Cl.: H01J 37/20, H01J 37/16

(54) **CHARGED PARTICLE DEVICE**

(30) Priority: 15.06.2010 JP 2010136330
(71) Applicant: Hitachi High-Technologies Corporation, Tokyo 105-8717 (JP)
(72) Inventor: ENOMOTO Hirohisa, Chiyoda-ku, Tokyo 100-8220 (JP); SUZUKI Wataru, Ibaraki 312-8504 (JP); KITAYAMA Shinya, Ibaraki 312-8504 (JP)
(74) Representative: Beetz & Partner
(86) International application number: PCT/JP2011/063310
(87) International publication number: WO 2011/158739

(57) **Abstract**

A charged particle device that can prevent an effect of a vibration and suppress relative displacement between a charged particle generator and a specimen stage without reducing a movement range of the specimen stage is achieved. The charged particle device (1) has a long cylindrical column (2) at its upper portion and a hollow specimen chamber (3) arranged under the column (2). The specimen chamber (3) is divided into a specimen chamber upper portion (3a) and a specimen chamber bottom portion (3b). A vertical vibration of the specimen chamber upper portion (3a) is larger than a horizontal vibration of the specimen chamber upper portion (3a). A horizontal vibration of the specimen chamber bottom portion (3b) is large. The column (2) has a charged particle gun and a detector. The column (1) and a specimen stage supporter (4) are held by the specimen chamber upper portion (3a), while the specimen stage supporter (4) holds the specimen stage (5). A central axis of the column (1) and a central axis of the specimen stage supporter (4) match each other or are parallel to each other. Even if an environmental sound is added to the column (2) or the specimen chamber (3), the column (2) and the specimen stage (5) are fixed to the specimen chamber upper portion (3a) and vibrate in an integrated manner. Thus, relative displacement hardly occurs between the charged particle generator and a specimen.

## Description

### Technical Field

The present invention relates to a charged particle device with a specimen stage.

### Background Art

A charged particle device emits charged particles toward a specimen for processing and observing the specimen. The specimen is placed on a stage called a specimen stage. Then, the specimen is processed into various shapes, being observed from various directions.

Thus, the specimen stage has a mechanism for driving the specimen stage in many directions including an in-plane direction and an out-of-plane direction. For example, the specimen stage has a multi-axis mechanism for driving the specimen stage in the in-plane direction and the out-of-plane direction, as in a technique described in Patent Document 1. If the specimen stage suffers from an external vibration such as a vibration resulting from an environmental sound or a floor vibration, relative displacement occurs between charged particles and the specimen on the specimen stage.

In such a case, a fluctuation occurs in an image observed by an electron microscope, resulting in a reduction of resolution thereof. Since, in an ion beam processing device, a position at which to process the specimen is shifted, the processing accuracy is reduced. Such devices have extremely fine resolutions and processing accuracies. As a result, applying very small vibrations to the devices will affect them.

In view of this, each of the devices is configured so that relative displacement hardly occurs between a specimen stage and a charged particle generator. For example, as in a technique described in Patent Document 2, the objective lens and the specimen stage are connected to each other by four bars such that relative displacement may not take place between the specimen stage and the charged particle generator.

### Prior Art Document

### Patent Documents

Patent Document 1: JP-2003-282016-A
Patent Document 2: JP-H6-176729-A

### Summary of the Invention

### Problem to be Solved by the Invention

However, in the conventional techniques, the specimen stage is held by a side surface of a specimen chamber, and thus a column holding position of the charged particle generator does not match a position at which the specimen stage is held, for example, as described in Patent Document 1.

Such a structure is adapted so that the column and the specimen stage may not vibrate in an integrated manner upon vibration of a device. Thus, even when the specimen stage is firmly fixed, relative displacement between the charged particle generator and the specimen stage is not reduced.

In order to reduce the relative displacement, it is conceivable that the specimen chamber could be made smaller so that the column holding position matches the position at which the specimen stage is held.

The thus-small specimen chamber, however, will limit the movement range of the specimen stage, thereby limiting ranges in which the specimen is processed and observed. In the structure described in Patent Document 2, if the columns are provided to have high rigidities in order to make relative displacement smaller, the columns need to be thick and thereby the movement range of the specimen stage will be limited. Since the specimen stage is held at lower portions of the columns, out-of-plane movement will also be limited.

An object of the present invention is to implement a charged particle device that can prevent an effect of vibration and suppress relative displacement between a charged particle generator and a specimen stage to the minimum without making narrow a range in which the specimen stage is movable.

### Means for Solving the Problem

In order to accomplish the aforementioned object, the invention is configured as follows.

A charged particle device according to the invention includes: a long cylindrical column; a specimen chamber that has a surface in which the column is installed in a direction perpendicular to the surface; a hollow specimen stage supporter that is installed on the surface in which the column is installed; and a specimen stage that is arranged in the supporter. The specimen stage may include a horizontal plane inclination mechanism held by the supporter, a vertical driving mechanism held by the horizontal plane inclination mechanism, a horizontal plane driving mechanism held by the vertical driving mechanism and a horizontal in-plane rotation mechanism held by the horizontal plane driving mechanism.
In addition, the charged particle device according to the invention may include an inclination axis rotation mechanism that is arranged on a side surface of the supporter so that an inclination axis of the horizontal plane inclination mechanism is perpendicular to a central axis of a rotation.
In addition, the charged particle device according to the invention may include a vertical driving mechanism that has an inclined driving surface.
In addition, the specimen stage supporter that is included in the charged particle device according to the invention may have a hole formed on a side surface of the specimen stage supporter.

### Effects of the Invention

According to the invention, there is provided the multi-axis charged particle device that prevents an effect of vibration and suppresses relative displacement between the charged particle generator and the specimen stage to the minimum without making narrow the movement range of the specimen stage.

### Brief Description of the Drawings

Fig. 1 is a cross-sectional view of a part of a side surface of a charged particle device according to a first embodiment of the invention.
Fig. 2 is a cross-sectional view of a part of a front surface of the charged particle device according to the first embodiment of the invention.
Fig. 3 is a cross-sectional view of a part of a plane surface of a specimen stage according to the first embodiment of the invention.
Fig. 4 is a perspective view of an essential part according to the first embodiment of the invention.
Fig. 5 is a cross-sectional view of a part of a side surface of a charged particle device according to a second embodiment of the invention.
Fig. 6 is a cross-sectional view of a part of a side surface of a charged particle device according to a third embodiment of the invention.
Fig. 7 is a cross-sectional view of a part of a side surface of a charged particle device according to a fourth embodiment of the invention.
Fig. 8 is a perspective view of an essential part of a charged particle device according to a fifth embodiment of the invention.
Fig. 9 is a perspective view of an essential of a charged particle device according to a sixth embodiment of the invention.
Fig. 10 is a perspective view of an essential of a charged particle device according to a seventh embodiment of the invention.
Fig. 11 is a perspective view of an essential of a charged particle device according to an eighth embodiment of the invention.
Fig. 12 is a perspective view of an essential of a charged particle device according to a ninth embodiment of the invention.
Fig. 13 is a perspective view of an essential of a charged particle device according to a tenth embodiment of the invention.

### Mode for Carrying out the Invention

Hereinafter, embodiments of the invention are described with reference to the accompanying drawings.

### First Embodiment

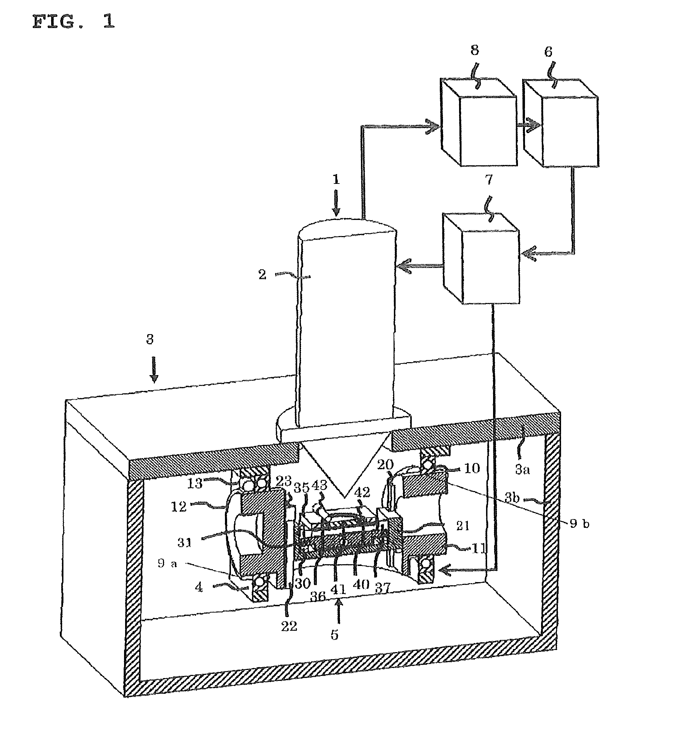

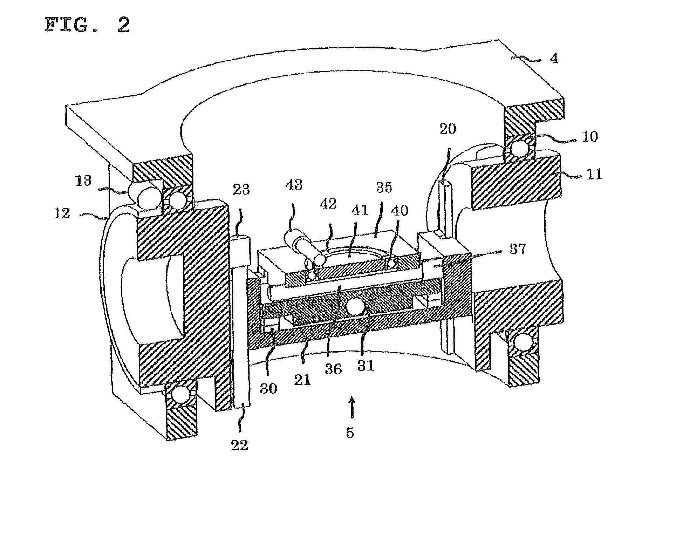

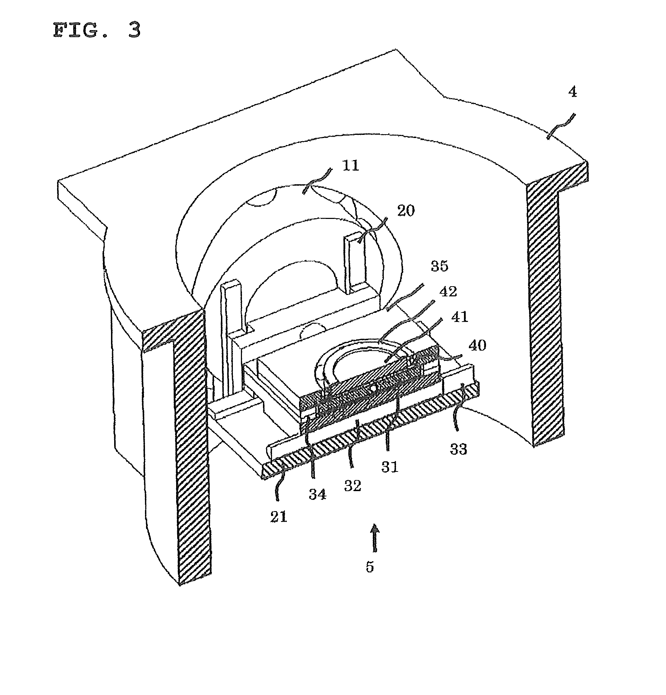

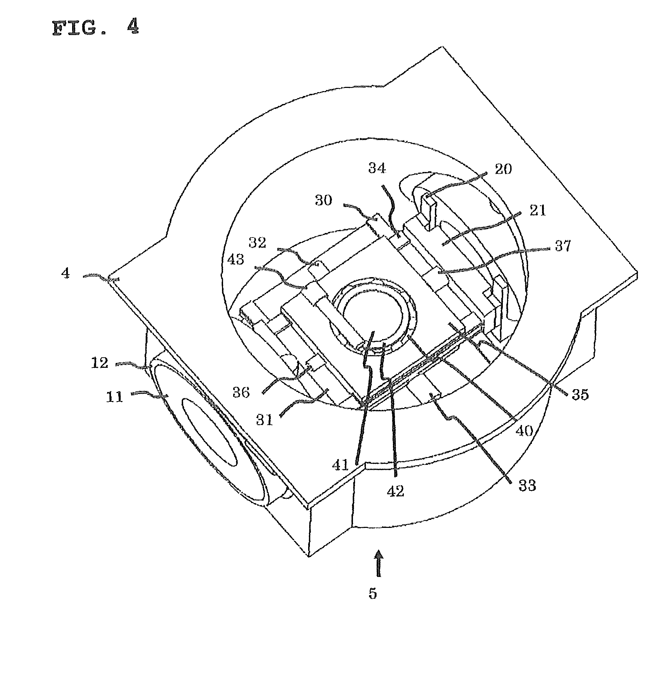

Figs. 1 to 4 are diagrams illustrating an outline configuration of a charged particle device according to the first embodiment of the invention. Fig. 1 is a cross-sectional view of essential part of a side surface of the charged particle device according to the first embodiment. Fig. 2 is a cross-sectional view of essential part of a front surface of the charged particle device according to the first embodiment. Fig. 3 is a cross-sectional view of a plane surface of a specimen stage according to the first embodiment, taken along a line nearly perpendicular to a direction along which the views illustrated in Figs. 1 and 2 are taken. Fig. 4 is a perspective view of an essential part according to the first embodiment.

In Figs. 1 to 4, the charged particle device 1 has a long cylindrical column 2 on its upper side and a hollow specimen chamber 3 on the lower side of the column 2. The specimen chamber 3 includes a specimen chamber upper portion 3a and a specimen chamber bottom portion 3b separated from each other. The column 2 is installed in and held by the specimen chamber upper portion 3a (column's fixed surface). The column 2 includes a charged particle gun (charged particle generating means) and a detector.

A hollow specimen stage supporter 4 is arranged on the specimen chamber upper portion 3a so that a central axis of the column 2 coincides with or is parallel to a central axis of the specimen chamber upper portion 3a that is a holder. The specimen stage supporter 4 has a specimen stage 5 therein.

In order to process or observe a specimen, an operator first configures settings for processing and observing the specimen while viewing a monitor 6. Setting conditions are transmitted from the monitor 6 to a control device 7. Control signals are transmitted from the control device 7 to the column 2 and the specimen stage 5. Then, the specimen chamber that is surrounded by the specimen chamber upper portion 3a and the specimen chamber bottom portion 3b is evacuated. The specimen stage 5 moves to a predetermined position. The charged particle gun of the column 2 emits charged particles toward the specimen placed on a horizontal rotation table 41 of the specimen stage 5.

The detection system of the column 2 detects the charged particles with which the specimen has been irradiated. The detection system transmits the detected data to an analyzer 8. An image of the specimen analyzed by the analyzer 8 is displayed on the monitor 6.

Circular holes 9a and 9b are formed in an inner wall of the specimen stage supporter 4 and face each other. Central axes of the circular holes 9a and 9b coincide with each other. Horizontal plane inclination bearings 10 are arranged in the holes 9a and 9b so that rotational axes of the two bearings 10 that face each other coincide with each other.

A horizontal plane inclination table 11 is arranged in inner rings of the bearings 10. A part of the horizontal plane inclination table 11 is formed in a circular shape. An end of the horizontal plane inclination table 11 is located on the outer side of the bearings 10. The shape of the horizontal plane inclination table 11 is not limited to the shape illustrated in the drawings. The horizontal plane inclination table 11 may be formed in another shape. A horizontal torque transmitter 12 that is, for example, a gear or the like is arranged on a circular end of the horizontal plane inclination table 11, for example. In addition, a horizontal rotation driver 13 that is, for example, an electric motor or the like is arranged on the specimen stage supporter 4 so as to be engaged with the horizontal torque transmitter 12. The horizontal inclination bearings 10, the horizontal plane inclination table 11, the horizontal torque transmitter 12 and the horizontal rotation driver 13 form an inclination mechanism.

In order to incline the horizontal plane of the horizontal plane inclination table 11, driving power and a control signal are supplied to the horizontal inclination driver 13 from a power supply (not illustrated) and the control device. Then, the driver 13 operates. Driving force is transmitted through the horizontal torque transmitter 12 to the horizontal plane inclination table 11. Then, the horizontal plane inclination table 11 and the horizontal inclination bearings 10 rotate. In this case, a position sensor may be arranged on the horizontal plane inclination table 11 for the control of an inclination angle.

The specimen may be extracted from the specimen table 5 through the circular inner portion of the horizontal plane inclination table 11.

Vertical movement linear guides 20 are arranged on the horizontal plane inclination table 11 in two rows and extend in a vertical direction. A vertical movement table 21 is held at opposite ends thereof by the vertical movement linear guides 20. The shape of the vertical movement table 21 is not limited to the shape illustrated in the drawings. A vertical driving force transmitter 22 that is, for example, a ball screw, a ball spline or the like is arranged on a central portion of one of the ends of the vertical movement table 21. A vertical driver 23 that is, for example, an electric motor or the like is arranged on a central portion of the horizontal plane inclination table 11 on the side of the specimen stage so that an axis of the vertical driver 23 coincides with an axis of the vertical driving force transmitter 22. The vertical movement linear guides 20, the vertical movement table 21, the vertical driving force transmitter 22 and the vertical driver 23 form a vertical driving mechanism.

In order to drive the vertical movement table 21, driving power and a control signal are supplied to the vertical driver 23 from the power supply (not illustrated) and the control device. Then, the vertical driver 23 operates. Driving force is transmitted through the vertical driving force transmitter 22 to the vertical movement table 21. Then, the vertical movement table 21 moves on the vertical movement linear guides 20. In this case, a position sensor may be arranged on the vertical movement table for the control of the position of the vertical movement table in the vertical direction.

The vertical driving force transmitter 22 is arranged on the central portion of the vertical movement table 21 in the horizontal direction. Thus, a moment about a vertical axis of a surface of the vertical movement table 21 hardly acts on the table 21 upon movement, and the vertical movement table 21 stably operates. In addition, since the vertical movement linear guides 20 hold opposite ends of the vertical movement table 23, the table 21 hardly rotates and stably operates.

Horizontal movement linear guides (a direction perpendicular to an inclination axis) 30 are arranged in two rows on the vertical movement table 21 and extend in a direction perpendicular to the horizontal plane inclination axis (axis extending in a direction in which the holes 9a and 9b of the specimen stage supporter 4 face each other) so that a wide gap exists between the horizontal movement linear guides 30. A horizontal movement table (the direction perpendicular to the inclination axis) 31 is held at opposite ends thereof by the horizontal movement linear guides (the direction perpendicular to the inclination axis) 30. The horizontal movement table (the direction perpendicular to the inclination axis) 31 is not limited to the table illustrated in the drawings and may be variously modified.

A horizontal driving force transmitter 32 (illustrated in Fig. 3) that is, for example, a ball screw, a ball spline or the like is arranged on a central portion of the horizontal movement table 31. A horizontal driver (the direction perpendicular to the inclination axis) 33 that is, for example, an electric motor or the like is arranged on the vertical movement table 21 so that an axis of the horizontal driver 33 coincides with an axis of the horizontal driving force transmitter 32.

In addition, horizontal movement linear guides (the direction perpendicular to the inclination axis) 34 are arranged in two rows on the horizontal movement table 31 and extend in the direction of the horizontal plane inclination axis and a wide gap exists between the horizontal movement linear guides 34.

A horizontal movement table (the direction of the inclination axis) 35 is held at opposite ends thereof by the horizontal movement linear guides (the direction of the inclination axis) 34. The horizontal movement table 35 is not limited to the table illustrated and may be variously modified. A horizontal driving force transmitter (the direction of the inclination axis) 36 that is, for example, a ball screw, a ball spline or the like is arranged on a central portion of the table 35. The horizontal movement linear guides 30, the horizontal movement table 31, the horizontal driving force transmitter 32, the horizontal driver 44, the horizontal movement linear guides 34 and the horizontal movement table 35 form a horizontal driving mechanism.

In addition, a horizontal driver (the direction of the inclination axis) 37 is arranged on the horizontal movement table (the direction of the inclination axis) 35. A horizontal driver (the direction of the inclination axis) that is, for example, an electric motor or the like is arranged on the horizontal movement table 35 so that an axis of the horizontal driver coincides with an axis of the horizontal driving force transmitter 36.

In order to move the horizontal movement table 35 in the horizontal direction, driving power and a control signal are supplied to the drivers 33 and 37 from the power supply (not illustrated) and the control device. Then, the drivers 33 and 37 operate. Driving force is transmitted from the drivers 33 and 37 through the transmitters 32 and 36 to the movement tables 31 and 35. Then, the movement tables 31 and 35 move on the linear guides 30 and 34. In this case, position sensors may be arranged on the tables 31 and 35 for the control of the positions of the tables 31 and 35.

Since the horizontal driving force transmitter (the direction perpendicular to the inclination axis) 32 is arranged on a central portion of the horizontal movement driver (the direction perpendicular to the inclination axis) 33, a moment about a vertical axis hardly acts on the table 32 upon a movement, and the table 32 stably operates. In addition, since the horizontal movement linear guides (the direction perpendicular to the inclination axis) 30 holds opposite ends of the horizontal movement table (the direction perpendicular to the inclination axis) 31, the table 31 hardly rotates and stably moves.

Since the horizontal driving force transmitter (the direction of the inclination axis) 36 is arranged on a central portion of the horizontal movement table (the direction of the inclination axis) 35, a moment about a vertical axis hardly acts on the table 35 upon a movement of the table 35 and the table 35 stably operates. The horizontal movement linear guides (the direction of the inclination axis) 34 hold opposite ends of the horizontal movement table (the direction of the inclination axis) 35. Thus, the table 35 hardly rotates and stably operates.

A horizontal rotation bearing 40 is arranged in the horizontal movement table (the direction of the inclination axis) 35 so that a rotary axis of the bearing extends in the vertical direction. A horizontal rotation table 41 is arranged in an inner ring of the bearing 40. The shape of the horizontal rotation table 41 is not limited to the shape illustrated in the drawings and may be variously modified. A horizontal torque transmitter 42 that is, for example, a gear or the like is arranged on an outer circumference of the table 41. A horizontal rotation driver 43 that is, for example, an electric motor or the like is arranged on the horizontal movement table 35 (the direction of the inclination axis) and engaged with the horizontal torque transmitter 42. The bearing 40, the horizontal rotation table 41, the horizontal torque transmitter 42 and the horizontal rotation driver 43 form a horizontal in-plane rotation mechanism.

In order to rotate the table 41 in a horizontal plane, driving power and a control signal are supplied to the driver 43 from the power supply (not illustrated) and the control device, and the driver 43 operates. Driving force is transmitted from the driver 43 through the transmitter 42 to the movement table 41. Then, the movement table 41 and the bearing 40 rotate. In this case, a position sensor may be arranged on the table for the control of the rotation angle in the horizontal plane.

In the first embodiment of the invention, the column 1 and the specimen stage supporter 4 are held by the specimen chamber upper portion 3a so that the central axis of the column 1 and the central axis of the specimen stage supporter 4 coincide with each other or are parallel to each other, while the column 1 has the charged particle generator and the specimen stage supporter 4 holds the specimen stage 5.

The column 2 and the specimen stage 5 are fixed to the specimen chamber upper portion 3a. Thus, even if an environmental sound is exerted on the column 2 or the specimen chamber 3, the column 2 and the specimen chamber 3 vibrate in an integrated manner. As a result, relative displacement hardly occurs between the charged particle generator and the specimen.

If the outer portion of the sample stage holder 4 is enlarged while the inner portion (on the side of the sample stage 5) of the sample stage holder 4 is not enlarged, the rigidity of the sample stage 5 can be increased without reducing the movement range of the sample stage 5, and relative displacement is reduced.

If the outer portion of the sample stage holder 4 and the internal space of the sample stage holder 4 are enlarged, the sample stage 5 has high rigidity and can move over the wide range.

Normally, a turbo-molecular pump is arranged under the specimen chamber. Since the specimen stage 5 is fixed to the specimen chamber upper portion 3a, the degree of freedom of where the turbo-molecular pump is located can be increased, compared with the case in which the sample stage is fixed to a bottom portion of the sample chamber.

### Second Embodiment

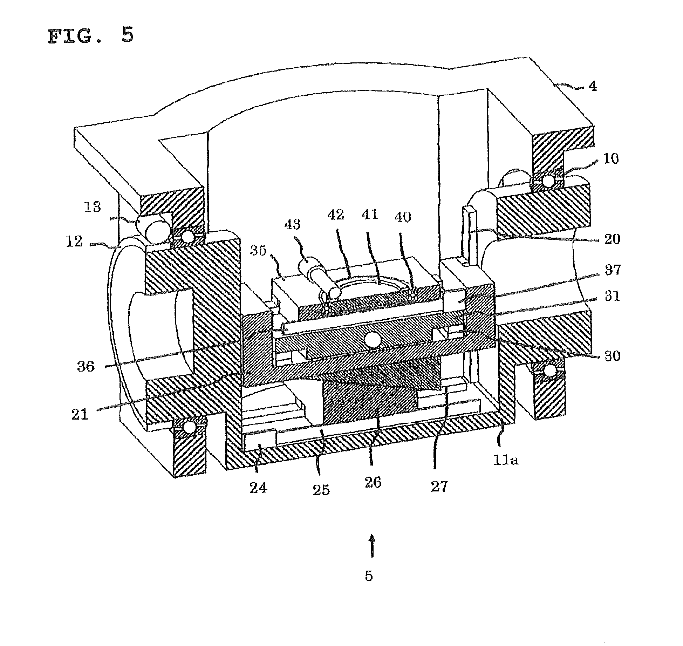

Fig. 5 is a cross-sectional view of a part of a front surface of a charged particle device according to a second embodiment of the invention. Fig. 5 corresponds to Fig. 2 illustrating the first embodiment.

In an example illustrated in Fig. 5, a horizontal plane inclination table 11a, an inclination-direction movement guide 26, a horizontal movement guide 27, a horizontal driving force transmitter 25 and a horizontal driver 24 are added to the example illustrated in Fig. 2. The horizontal plane inclination table 11a is held at opposite ends thereof by the horizontal inclination bearings 10. The inclination-direction movement guide 26 is arranged between the horizontal plane inclination table 11a and the vertical movement table 21 and has an inclined surface. The horizontal movement guide 27 holds the inclination-direction movement guide 26 at opposite ends thereof. The horizontal driving force transmitter 25 is arranged at a central portion of the inclination-direction movement guide 26 and is, for example, a ball screw, a ball spline or the like. The horizontal driver 24 is installed to the horizontal driving force transmitter 25.

The vertical movement linear guides 20 are held by an inner-side side wall of the horizontal plane inclination table 11a.

In Fig. 5, in order to drive the vertical movement table 21 and move the vertical movement table 21 in the vertical direction, driving power and a control signal are supplied to the driver 24 from the power supply (not illustrated) and the control device. Then, the driver 24 operates. Driving force is transmitted from the driver 24 through the transmitter 25 to a lower portion of the inclination-direction movement guide 26. The lower portion of the inclination-direction movement guide 26 moves along the horizontal movement guide 27. The inclined surface of the guide 26 slides. The inclined surface is located between upper and lower portions of the guide 26. Then, the vertical movement table 21 and an upper portion of the inclination-direction movement guide 26 move. In this case, a position sensor may be arranged on the table 21 for the control of the position of the table 21 in the vertical direction.

Other configurations are the same as the first embodiment, and a detailed description and illustration thereof are omitted.

The charged particle device according to the second embodiment of the invention is configured as described above and can obtain effects that are the same as or similar to the first embodiment. In addition, intervals between movement operations of the vertical movement table 21 in the vertical direction can be made fine, compared with the first embodiment.

The intervals between the movement operations can be changed by changing an angle of the inclined surface of the inclination-direction movement guide 26.

In addition, when a dimension of the inclination-direction movement guide 26 in a direction in which the guide 26 moves is increased, the movement range can be increased.

Since the inclination-direction movement guide 26 holds the vertical movement table 21 from the lower side, a holding rigidity is increased, compared with the first embodiment.

### Third Embodiment

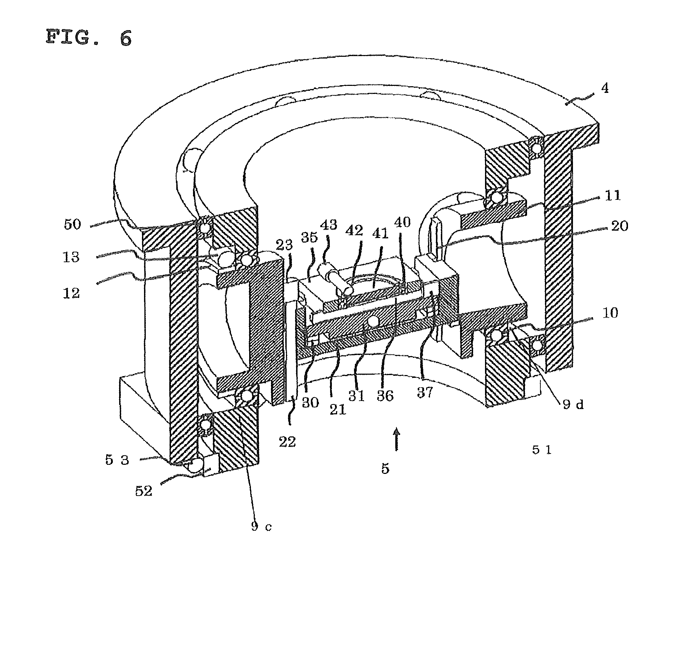

Fig. 6 is a cross-sectional view of a part of a front surface of a charged particle device according to a third embodiment of the invention. Fig. 6 corresponds to Fig. 2 illustrating the first embodiment.

In Fig. 6, an inclination axis rotation bearing 50 is arranged on the inner side of the specimen stage supporter 4 so that a rotational axis is parallel to the vertical axis. An inclination axis rotation table 51 is arranged in an inner ring of the bearing 50. The inclination axis rotation table 51 has circular holes 9c and 9d that face each other. An inclination axis torque transmitter 52 is arranged on a lower end of the inclination axis rotation table 51. An inclination axis rotation driver 53 is arranged on a lower end of the specimen stage supporter 4. The horizontal plane inclination bearings 10 are arranged in the holes 9c and 9d of the inclination axis rotation table 51.

In order to rotate the inclination axis rotation table 51, driving power and a control signal are supplied to the inclination axis rotation driver 53 from the power supply (not illustrated) and the control device. Then, the inclination axis rotation driver 53 operates. Driving force is transmitted from the inclination axis rotation driver 53 through the inclination axis torque transmitter 52 to the inclination axis rotation table 51 on which a horizontal plane inclination mechanism is arranged. Then, the rotation table 51 and the bearing 50 rotate. In this case, a position sensor may be arranged on the rotation table 51 for the control of a rotational angle of the inclination axis rotation table 51.

Other configurations are the same as the first embodiment and a detailed description and illustration thereof are omitted.

The charged particle device according to the third embodiment of the invention is configured as described above and can obtain effects that are the same as or similar to the first embodiment. Even when the horizontal movement linear guides 30 are arranged while being inclined, the inclination axis rotation table 51 is rotated to correct the inclination.

A device provided with a plurality of columns, for example, a dual beam device, can make orientations of the columns to coincide with each other and can change inclination axes.

### Fourth Embodiment

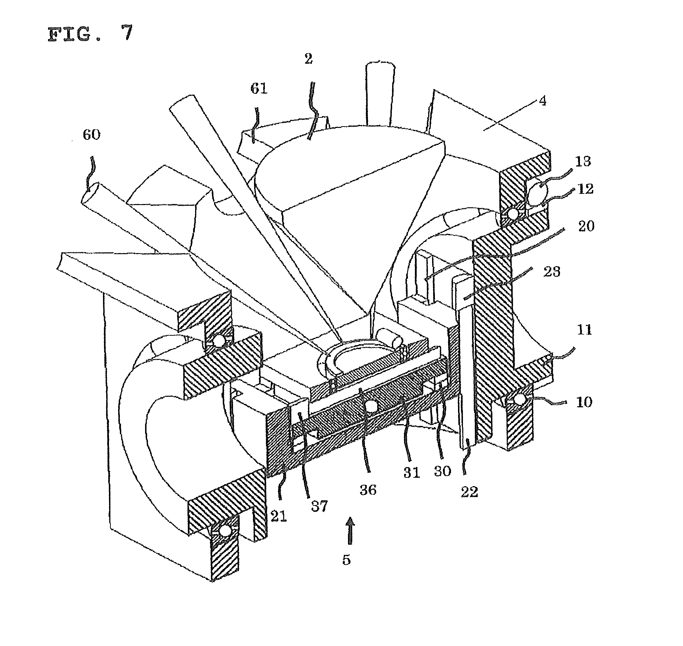

Fig. 7 is a cross-sectional view of a part of a front surface of a charged particle device according to a fourth embodiment of the invention. Fig. 7 corresponds to Fig. 2 illustrating the first embodiment.

An example illustrated in Fig. 7 is different from the example illustrated in Fig. 2 in that a plurality of openings 61 are formed in a side wall of the stage holder 4 in the example illustrated in Fig. 7.

Other configurations are the same as the first embodiment.

The charged particle device according to the fourth embodiment of the invention is configured as described above and can obtain effects that are the same as or similar to the first embodiment. A probe manipulator 60 can be inserted in the stage 5 through the openings 61. In addition, a device provided with a plurality of columns, for example, a dual beam device, can irradiate the specimen with charged particles from the upper side of the device in the vertical direction and can irradiate the specimen with charged particles in a direction in addition to the vertical direction.

The fourth embodiment can be applied to the first to third embodiments.

### Fifth Embodiment

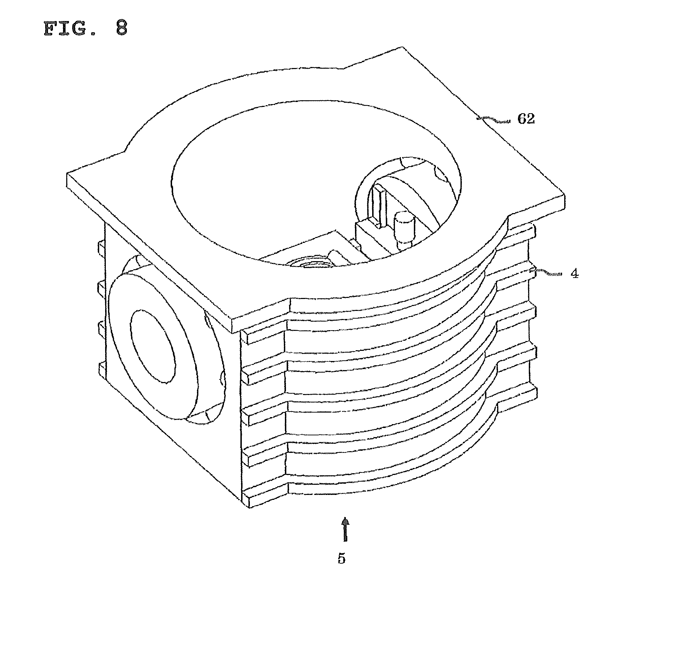

Fig. 8 is a perspective view of an essential part of a charged particle device according to a fifth embodiment of the invention.

In Fig. 8, a plurality of ribs 62 are formed on an outer side surface of the stage holder 4. The plurality of ribs 62 can be configured so that the thicknesses of the ribs 62 in the vertical direction vary. In this case, the ribs 62 can be configured so that the thickness of the rib 62 located on the lower end of the stage holder 4 is largest.

The shapes and number (6) of the ribs 62 may not be the shapes illustrated in Fig. 8 and the number illustrated in Fig. 8.

Other configurations are the same as the first embodiment, and a detailed description and illustration thereof are omitted.

The charged particle device according to the fifth embodiment of the invention is configured as described above and can obtain effects that are the same as or similar to the first embodiment. An out-of-plane bending rigidity of the side surface of the stage holder 4 can be increased and a vibration that causes deformation in an out-of-plane bending direction can be reduced, compared with the first embodiment. If the thickness of the side surface of the stage holder 4 is reduced and the thicknesses of the ribs 62 are increased, the weight of the stage holder 4 can be reduced and the rigidity of the stage holder 4 can be increased.

### Sixth Embodiment

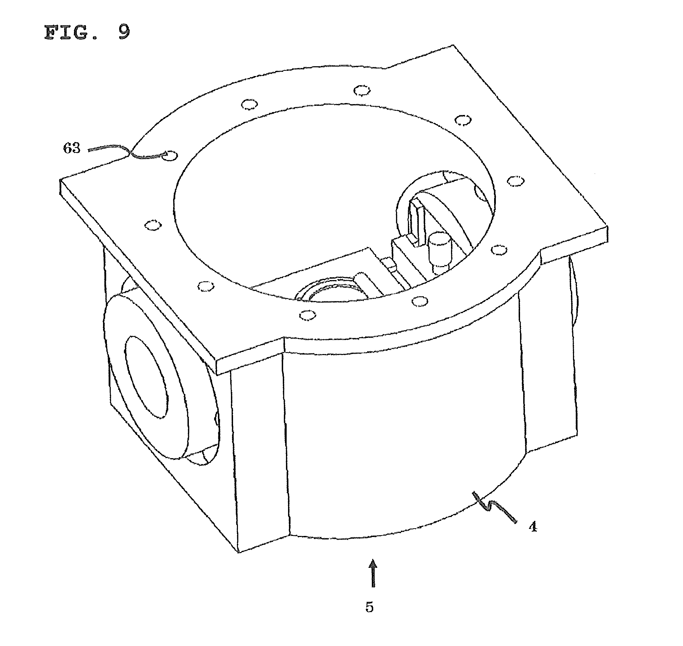

Fig. 9 is a perspective view of an essential part of a charged particle device according to a sixth embodiment of the invention.

In Fig. 9, the stage holder 4 has a plurality of cores 63 that have a higher rigidity than the stage holder 4 and extend from an upper end of the stage holder 4 to the lower end of the stage holder 4 in the vertical direction. The shapes and number of the cores 63 may not be the shapes and number illustrated in Fig. 9.

Other configurations are the same as the first embodiment.

The charged particle device according to the sixth embodiment of the invention is configured as described above and can obtain effects that are the same as or similar to the first embodiment. A vertical tension-compression rigidity of the stage holder 4 can be increased and deformation, attributable to the weight of the stage holder 4, of the stage holder 4 in the vertical direction can be reduced, compared with the first embodiment.

### Seventh Embodiment

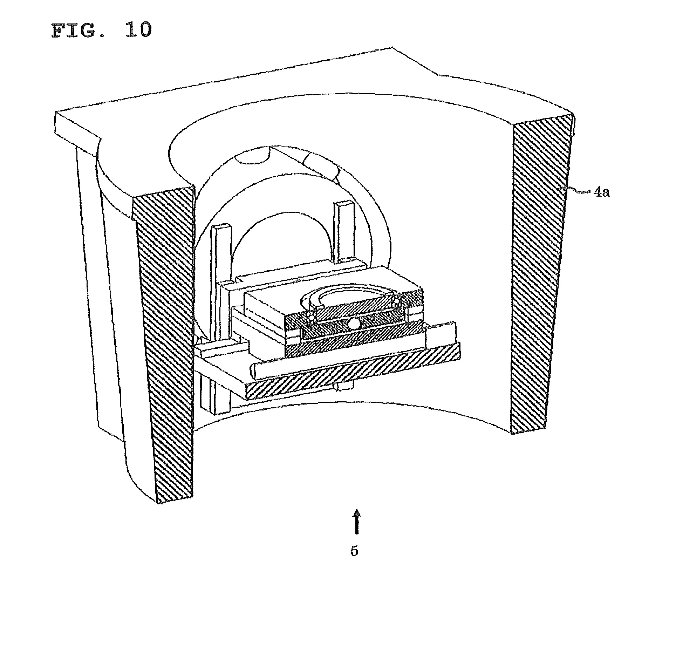

Fig. 10 is a cross-sectional view of an essential of a charged particle device according to a seventh embodiment of the invention while omitting a part of the charged particle device.

In Fig. 10, the thickness of the upper end of the stage holder 4 is largest and the thickness of the lower end of the stage holder 4 is smallest. The thickness of the stage holder 4 becomes smaller toward the side of the lower end of the stage holder 4.

Other configurations are the same as the first embodiment, and a detailed description and illustration thereof are omitted.

The charged particle device according to the seventh embodiment of the invention is configured as described above and can obtain effects that are the same as or similar to the first embodiment. A fixed part can be strong against the weight of the stage holder 4, and the weight of the stage holder 4 can be reduced, compared with the first embodiment.

### Eighth Embodiment

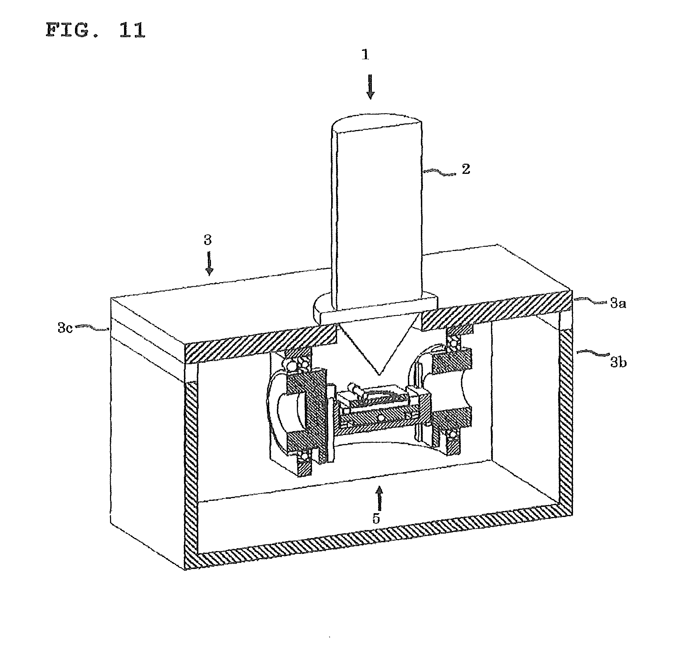

Fig. 11 is a cross-sectional view of an essential of a charged particle device according to an eighth embodiment of the invention.

In Fig. 11, the specimen chamber 3 has an attenuation material 3c arranged between the specimen chamber upper portion 3a and the specimen chamber bottom portion 3b.

Other configurations are the same as the first embodiment, and a detailed description and illustration thereof are omitted.

The charged particle device according to the eighth embodiment of the invention is configured as described above and can obtain effects that are the same as or similar to the first embodiment. Vibrations that are applied to the column 2 and the stage 4 are small, compared with the first embodiment.

### Ninth Embodiment

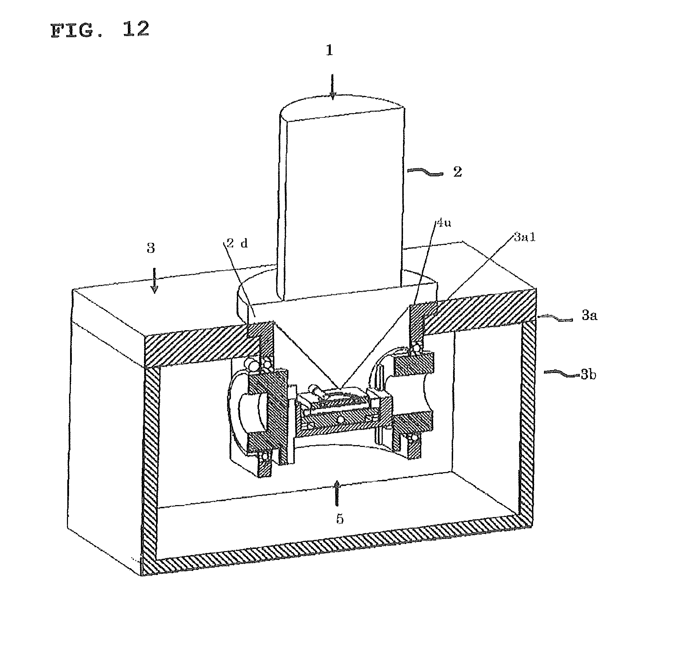

Fig. 12 is a cross-sectional view of an essential part of a charged particle device according to a ninth embodiment of the invention.

In Fig. 12, the specimen chamber upper portion 3a has an opening 3a1 formed therein and has a step at a central part of the opening 3a1. A flange 4u of an upper end portion of the stage holder 4 is installed on the step of the opening 3a1 from the upper side. The column 2 is installed on the flange 4u of the upper end portion of the stage holder 4 from the upper side. A flange 2d of a lower portion of the column 2 is fixed to the flange 4u of the upper end portion of the stage holder 4 through a bolt or the like and thereby integrated with the flange 4u of the upper end portion of the stage holder 4.

Other configurations are the same as the first embodiment, and a detailed description and illustration thereof are omitted.

The charged particle device according to the ninth embodiment of the invention is configured as described above and can obtain effects that are the same as or similar to the first embodiment. The stage holder 4 can be crimped to the specimen chamber upper portion 3a, compared with the first embodiment.

### Tenth Embodiment

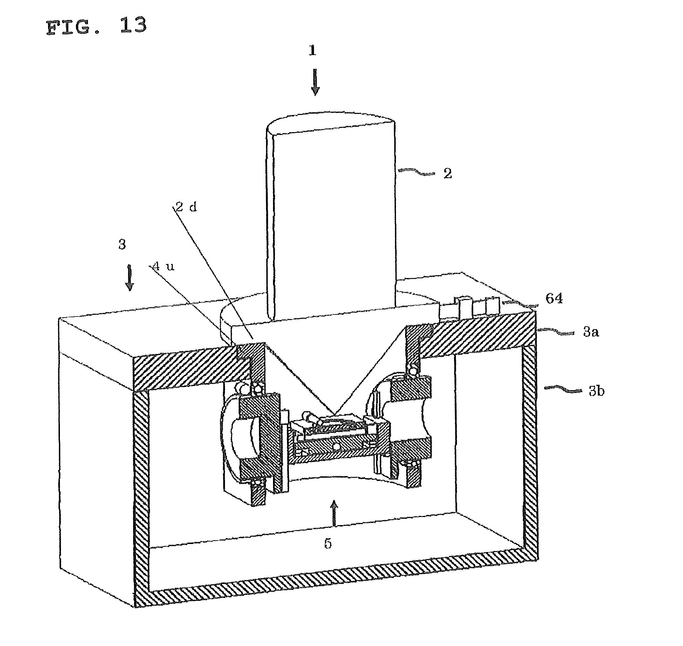

Fig. 13 is a cross-sectional view of an essential of a charged particle device according to a tenth embodiment of the invention.

In Fig. 13, the specimen chamber upper portion 3a has the opening 3a1 formed therein and has the step at the central part of the opening 3a1. The flange 4u of the upper end portion of the stage holder 4 is installed on the step of the opening 3a1 from the upper side. The plane of the flange 4u of the upper end portion of the stage holder 4 is made flush with that of the specimen chamber upper portion 3a. The column 2 is installed on the flange 4u of the upper end portion of the stage holder 4 from the upper side. The flange 2d of the lower portion of the column 2 is fixed to the flange 4u of the upper end portion of the stage holder 4 through a bolt or the like and thereby integrated with the flange 4u of the upper end portion of the stage holder 4.

The flange 2d of the lower portion of the column 2 is larger than the flange 4u of the upper end portion of the stage holder 4. A position adjustment screw 64 is arranged on the specimen chamber upper portion 3a on the same axis as a movement axis of the stage 5, while the movement axis extends in the horizontal direction. In order to adjust the position of the column 2, the bolt that is used to fix the column 2 is removed, the position adjustment screw 64 is rotated, and the screw 64 is moved while pushing the column 2.

Other configurations are the same as the first embodiment, and a detailed description and illustration thereof are omitted.

The charged particle device according to the tenth embodiment of the invention is configured as described above and can obtain effects that are the same as or similar to the first embodiment. An inclination axis of the stage 5 and the central axis of the column 2 can be adjusted by the position adjustment screw 64.

### Description of Reference Numerals

1 ··· Charged particle device, 2 ··· Column, 2d, 4d ··· Flange, 3a ··· Specimen chamber upper portion, 3a1 ··· Opening, 3b ··· Specimen chamber bottom portion, 3c ··· Attenuation material, 4, 4a ··· Specimen stage supporter, 5 ··· Specimen stage, 6 ··· Monitor, 7 ··· Control device, 8 ··· Analyzer, 9a to 9d ··· Hole, 10 ··· Horizontal plane inclination bearing, 11, 11a ··· Horizontal plane inclination table, 12 ··· Horizontal torque transmitter, 13 ··· Horizontal rotation driver, 20 ··· Vertical movement linear guide, 21 ··· Vertical movement table, 22 ··· Vertical driving force transmitter, 23 ··· Vertical driver, 24 ··· Horizontal driver, 25 ··· Horizontal driving force transmitter, 26 ··· Inclination-direction movement guide, 27 ··· Horizontal movement guide, 30 ··· Horizontal movement linear guide (direction perpendicular to inclination axis), 31 ··· Horizontal movement table (direction perpendicular to inclination axis), 32 ··· Horizontal driving force transmitter (direction perpendicular to inclination axis), 33 ··· Horizontal driver (direction perpendicular to inclination axis), 34 ··· Horizontal movement linear guide (direction of inclination axis), 35 ··· Horizontal movement table (direction of inclination axis), 36 ··· Horizontal driving force transmitter (direction of inclination axis), 37 ··· Horizontal driver (direction of inclination axis), 40 ··· Horizontal rotation bearing, 41 ··· Horizontal rotation table, 42 ··· Horizontal torque transmitter, 43 ···Horizontal rotation driver, 50 ··· Inclination axis rotation bearing, 51 ··· Inclination axis rotation table, 52 ··· Inclination axis torque transmitter, 53 ··· Inclination axis rotation driver, 60 ··· Probe manipulator, 61 ··· Opening, 62 ··· Rib, 63 ··· Core, 64 ··· Position adjustment screw

## Claims

1. A charged particle device comprising:
a long cylindrical column (2) that has charged particle generating means;
a specimen chamber (3) that has a column fixing surface to which an end of the column (2) is fixed;
a specimen stage supporter (4) that is arranged within the specimen chamber (3) and fixed to the column fixing surface; and
a specimen stage that is held by the specimen stage supporter (4) and holds a specimen that is irradiated with charged particles emitted by the charged particle generating means.

2. The charged particle device according to Claim 1, wherein the specimen stage (5) includes an inclination mechanism (10, 11, 12, 13) that inclines the specimen with respect to a charged particle beam formed by the charged particles,
a vertical driving mechanism (20, 21, 22, 23, 24) that is held by the inclination mechanism (10, 11, 12, 13) and moves the specimen in a vertical direction,
a horizontal driving mechanism (30, 31, 32, 33, 34, 35) that is held by the vertical driving mechanism and moves the specimen in a horizontal direction, and
a horizontal in-plane rotation mechanism (40, 41, 42, 43) that is held by the horizontal driving mechanism and rotates the specimen in a horizontal plane.

3. The charged particle device according to Claim 2, wherein the inclination mechanism (10, 11, 12, 13) includes
inclination bearings (10) that are arranged in the specimen stage supporter (4),
a horizontal plane inclination table (11) that is held by inner rings of the inclination bearings (10),
a horizontal torque transmitter (12) that contacts the horizontal plane inclination table, and
a horizontal rotation driver (13) that is held by the specimen stage supporter and transmits torque to the horizontal torque transmitter.

4. The charged particle device according to Claim 3, wherein the vertical driving mechanism (20, 21, 22, 23) includes
a vertical movement table (21) that holds the horizontal driving mechanism, and
vertical movement linear guides (20) that guide the vertical movement table in the vertical direction.

5. The charged particle device according to Claim 2,
wherein the specimen stage supporter (4) includes two openings that hold the inclination mechanism (10, 11, 12, 13) and face each other.

6. The charged particle device according to Claim 1, wherein a plurality of ribs (62) are formed on an outer surface of the specimen stage supporter (4).

7. The charged particle device according to Claim 1, wherein the specimen stage supporter (4) has cores therein.

8. The charged particle device according to Claim 1, wherein the specimen stage supporter (4) is configured so that the thickness of the specimen stage supporter (4) becomes smaller toward the opposite side of the column fixing surface.

9. The charged particle device according to Claim 1, wherein the specimen chamber (3) has the column fixing surface, a specimen chamber bottom portion (3b) holding the column fixing surface, and an attenuation material (3c) arranged between the column fixing surface and the specimen chamber bottom portion (3b).

10. The charged particle device according to Claim 1, further comprising
a position adjustment screw (64) that is arranged on the column fixing surface and adjusts the position of the column (2).
